(19) Europäisches Patentamt
European Patent Office
Office européen des brevets

(11) **EP 2 315 085 B1**

(12) **FASCICULE DE BREVET EUROPEEN**

(45) Date de publication et mention
de la délivrance du brevet:
**06.06.2018 Bulletin 2018/23**

(51) Int Cl.:
***G01R 33/385*** *(2006.01)* ***G06F 9/22*** *(2006.01)*

(21) Numéro de dépôt: **10306149.5**

(22) Date de dépôt: **22.10.2010**

(54) **Dispositif de correction de signaux de consigne et système de génération de gradients comportant un tel dispositif**

Berichtigungsvorrichtung von Einstellwerten, und System zur Erzeugung von Gradienten, das eine solche Vorrichtung umfasst

Device for correcting set points and gradient generation system comprising such a device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.10.2009 FR 0957487**

(43) Date de publication de la demande:
**27.04.2011 Bulletin 2011/17**

(73) Titulaire: **Bruker Biospin**
**67160 Wissembourg (FR)**

(72) Inventeur: **Schaefer, Ernest**
**67160 Rott (FR)**

(74) Mandataire: **Nuss, Laurent et al**
**Cabinet Nuss**
**10, rue Jacques Kablé**
**67080 Strasbourg Cedex (FR)**

(56) Documents cités:
**EP-A2- 1 176 718    GB-A- 2 149 509**
**US-A- 4 743 851    US-A- 5 349 296**

**Description**

La présente invention concerne le domaine du traitement du signal, plus particulièrement de la correction des signaux.

Plus précisément, l'invention a pour objet un dispositif numérique permettant le calcul, en temps réel, d'un signal de consigne corrigé et destiné notamment à être employé dans les unités de génération de gradients de champ magnétique.

Ces dernières sont communément mises en oeuvre dans la spectrométrie par résonance magnétique nucléaire (RMN) et les systèmes d'imagerie par résonance magnétique (IRM).

De manière connue, les gradients sont engendrés par des bobines placées à l'intérieur de l'aimant générant le champ magnétique principal constant. Ces bobines sont pilotées par des amplificateurs de courant, leur consigne étant habituellement donnée en tension et consistant généralement en une séquence d'impulsions.

Cette consigne est générée par un dispositif numérique dont l'entrée est un séquenceur, constituant un générateur d'impulsions programmable, et la sortie un étage de conversion numérique-analogique donnant la tension de consigne.

Le générateur d'impulsions est programmé en fonction du type d'analyse devant être effectuée par le spectromètre ou l'imageur.

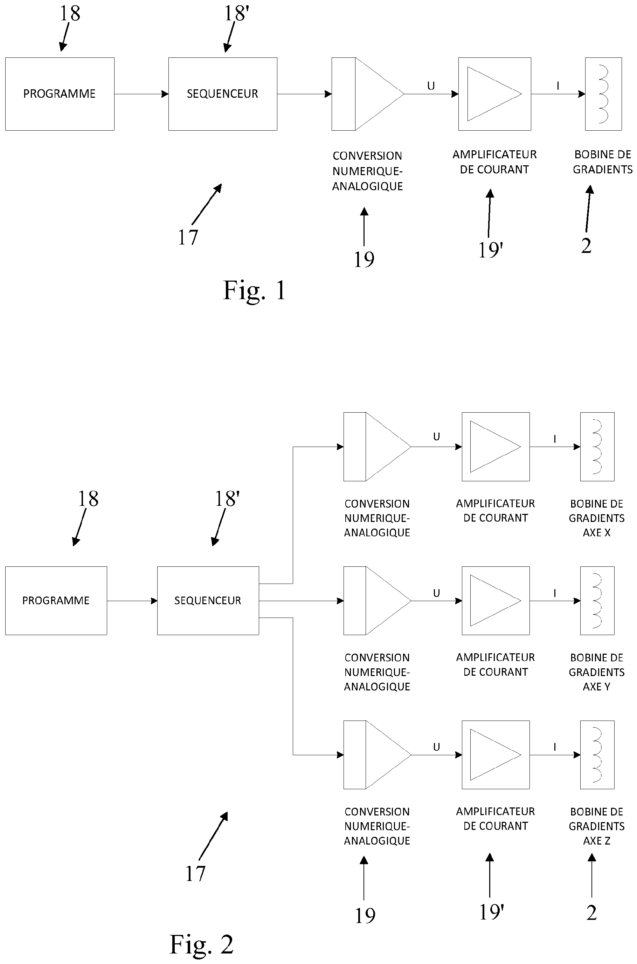

La figure 1 annexée montre les différentes composantes constitutives essentielles d'un système de génération de gradients.

Une configuration habituelle d'un tel système permet de générer des gradients de champs suivant les trois axes (X, Y et Z, ce dernier étant colinéaire avec le champ principal), comme représenté sur la figure 2 annexée.

D'autres configurations de systèmes sont également connues et mises en oeuvre.

Il est également connu que, lors de la variation du champ magnétique dans une bobine de gradient, des courants de Foucault apparaissent sur des éléments conducteurs, externes à la bobine, soumis à ce champ. Ces courants produisent un champ magnétique s'opposant au champ des gradients.

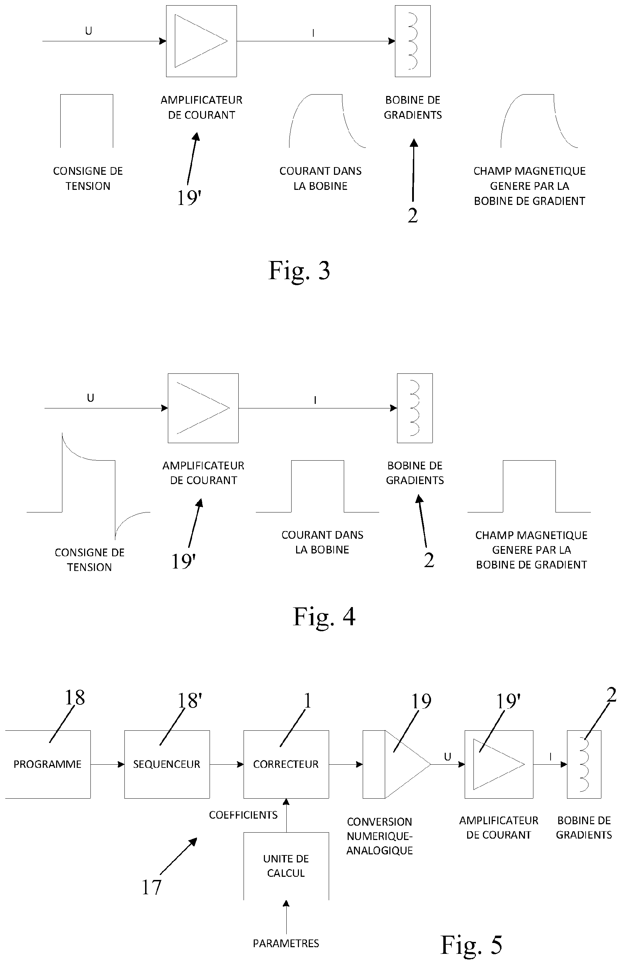

En considérant, par exemple, une bobine de gradient traversée par une impulsion de courant, le temps d'établissement du champ magnétique créé par cette bobine sera influencé par le champ engendré par les courants de Foucault. Ce phénomène est illustré sur la figure 3 annexée (illustration de l'effet des courants de Foucault sur le champ magnétique généré par une bobine de gradient).

La dégradation du champ des gradients par celui produit par les courants de Foucault a une influence néfaste sur les performances du spectromètre ou de l'imageur. Il est par conséquent nécessaire de réduire au maximum l'effet des courants de Foucault sur le champ des gradients.

A cette fin, une correction (du type préaccentuation par exemple) peut être appliquée sur la consigne en tension afin de compenser l'effet du champ opposé (la figure 4 annexée illustre une telle correction des effets des courants de Foucault).

Les solutions numériques proposées à ce jour pour réaliser une telle correction sont principalement de deux types, à savoir, les solutions entièrement matérielles (basées sur des machines à états par exemple) et les solutions de nature logicielle (mise en oeuvre sur un microprocesseur de traitement de signaux DSP, par exemple).

Le premier type de solution résulte en une implémentation rigide et figée et le second type de solution fait état de performances limitées.

Par le document US 5 349 296, on connaît un imageur RMN intégrant notamment un système d'alimentation des bobines de gradients, apte à fournir des signaux de consignes spécifiques à chaque canal et formés à partir de séries de codes décrivant les profils d'onde à appliquer.

Selon ce document, le système d'alimentation peut intégrer, en outre, sans que leur nature soit davantage précisée, des moyens de correction de pré-emphase présentant sensiblement les caractéristiques du préambule de la revendication 1, mais agissant sur des signaux analogiques délivrés aux différents canaux et utilisant des paramètres prédéfinis.

Ainsi, ces moyens de correction connus n'agissent pas sur des données numériques et, de plus, ils ne permettent pas de réaliser une correction par fonctionnement récursif.

Il en résulte un mode de correction limité, totalement figé et dont les performances ne peuvent être aisément estimées à l'avance, et sont en tout état de cause limitées.

La présente invention a notamment pour but de proposer une solution améliorée permettant de surmonter au moins certaines, préférentiellement toutes, les limitations des solutions mentionnées ci-dessus.

De plus, la solution proposée par l'invention devrait présenter une souplesse de mise en oeuvre à deux niveaux, à savoir, d'une part, pour un même type de traitement correctif, permettre l'utilisation de paramètres de correction aisément modifiables, manuellement ou automatiquement, et, d'autre part, la réalisation de traitements correctifs de natures différentes, ce sans nécessiter de modification de la structure matérielle du dispositif.

En outre, la solution proposée par l'invention devrait également permettre, d'une part, une bonne prédictibilité des performances et, d'autre part, une bonne gestion de l'utilisation des ressources matérielles mises en oeuvre, du fait d'une structure et d'une constitution simples.

A cet effet, l'invention a pour objet un dispositif de correction numérique présentant les caractéristiques du préambule de la revendication 1 et faisant également état des caractéristiques de la partie caractérisante de cette revendication.

Bien que de nombreuses applications de ce dispositif de correction soient envisageables, il est plus particulièrement fait état dans la présente de sa mise en oeuvre dans le contexte RMN/IRM.

Ainsi, l'invention concerne également un système de génération de gradients de champ magnétique comprenant des moyens de génération d'un signal de consigne numérique, par exemple sous la forme d'une séquence d'impulsions, des moyens de conversion et d'amplification du signal de consigne, le cas échéant propres à une voie, et une ou plusieurs bobine(s) de génération de gradients alimentée(s) par le signal ou les signaux amplifiée(s) fourni(s) par les moyens de conversion et d'amplification associés, le cas échéant respectivement correspondant, ledit système comportant également un dispositif de correction du signal de consigne avant sa conversion analogique et son amplification, et le cas échéant sa démultiplication, système caractérisé en ce que le dispositif de correction est un dispositif tel que décrit ci-dessus.

Le procédé de correction numérique résultant de la mise en oeuvre de ces différentes dispositions matérielles et logicielles et ressortant de la revendication 12, consiste à générer, dans le contexte de la production de gradients de champ magnétique, une correction en temps réel par un dispositif numérique inséré entre le générateur d'impulsions et l'étage de conversion numérique-analogique dans un système de génération du type précité.

Le dispositif de correction peut, par exemple, mais non limitativement, implémenter un filtre passe-haut numérique afin d'appliquer une préaccentuation ou une prédistorsion sur le signal de consigne (voir la figure 4 annexée). Le dispositif de correction numérique selon l'invention sera également appelé « correcteur » par la suite.

Etant donné que la correction apportée est avantageusement paramétrable (en rapport avec les caractéristiques de la bobine de gradients ou de l'amplificateur par exemple), les calculs effectués par le correcteur prennent en considération des coefficients provenant d'un dispositif externe. Ces coefficients peuvent être calculés en fonction de paramètres entrés manuellement par l'opérateur ou par un dispositif automatisé.

Les paramètres précités, dont l'exploitation permet de déterminer les coefficients de correction mis en oeuvre par le dispositif de correction, peuvent par exemple être déterminés ou résulter de mesures effectuées préalablement et permettant de relever les effets des courants de Foucault (voir par exemple WO 89/08852).

Une fois établis, ces coefficients ne varient plus tant que les composants du système ne changent pas, leur calcul ne relève donc pas de l'aspect temps réel contrairement aux opérations effectuées par le correcteur.

Toutefois, leurs valeurs peuvent être aisément modifiées soit par l'utilisateur (programmation), soit de manière automatique, en fonction de modifications matérielles et/ou d'environnement.

En outre, compte tenu de son mode de réalisation (architecture microprogrammée), les performances en termes de rapidité de traitement du correcteur dépendent essentiellement de la fréquence d'horloge appliquée, et des cycles de traitement de quelques centaines de nanosecondes peuvent être aisément atteints. De plus, le niveau de performance du correcteur peut être estimé par avance.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :

la figure 5 est un schéma bloc de principe d'un système de génération de gradients de champ magnétique intégrant un dispositif de correction ou correcteur selon l'invention ;
la figure 6 est un schéma de principe illustrant la constitution d'un dispositif de correction selon un mode de réalisation de l'invention ;
la figure 7 illustre schématiquement les différents signaux d'entrée et de sortie d'un micro-séquenceur faisant partie du dispositif de la figure 6 ;
la figure 8 est un schéma bloc de principe d'un ensemble fonctionnel [unité de traitement/mémoires de travail] faisant partie du dispositif de la figure 6 ;
la figure 9 illustre schématiquement la constitution de la mémoire de stockage des microinstructions faisant partie du dispositif de la figure 6, ainsi que la constitution et l'agencement d'une ligne de microinstructions,
la figure 10 est une représentation de principe illustrant une application du dispositif de la figure 6 sous la forme de trois cellules de filtrage en parallèle, et,
les figures 11 et 12 sont des représentations de principe illustrant les contenus des mémoires ou des zones de mémoires stockant respectivement les données (fig. 11) et les coefficients de correction (fig. 12) et associées à l'unité de traitement comme représenté sur la figure 6.

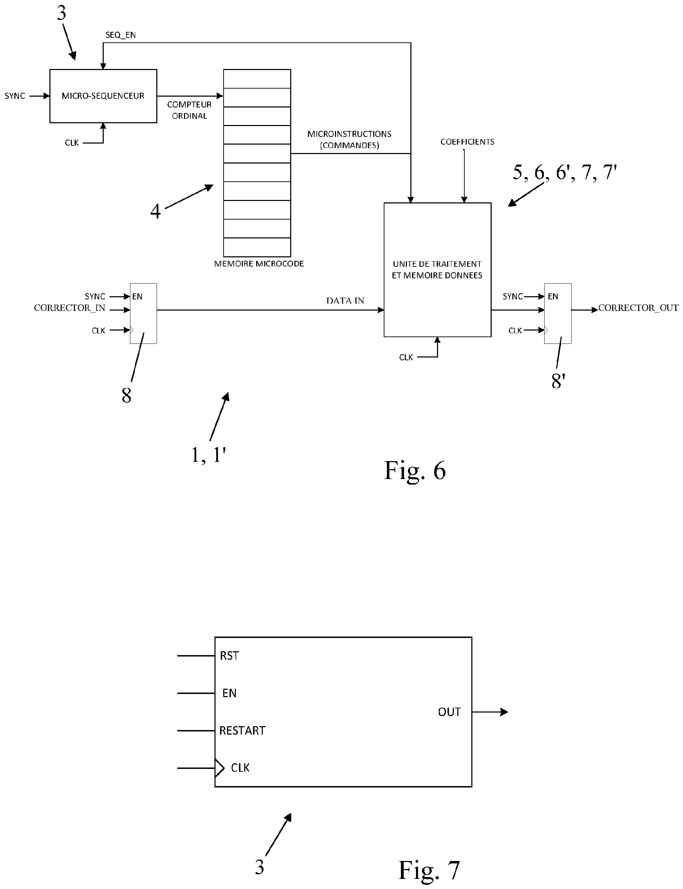

La figure 6 des dessins annexés montre, en relation avec les figures 7 à 9, un dispositif 1 de correction en temps réel de signaux de consigne ou de commande en fonction de facteurs ou de coefficients de correction ou de compensation fournis, en particulier pour la correction des signaux de consigne destinés à la commande de bobines de gradients 2 d'un appareil de spectrométrie ou d'imagerie par résonance magnétique nucléaire.

Un tel dispositif 1 est destiné à recevoir en entrée des signaux de consigne numériques originels et à délivrer à sa sortie des signaux de consigne qui ont été modifiés ou corrigés pour compenser les défauts, limitations, perturbations, interférences, effets négatifs ou analogues rencontrés ultérieurement lors du traitement, de la transmission, de la transformation et/ou de l'application desdits signaux de consigne.

Conformément à l'invention, ledit dispositif de correction 1 consiste en au moins un circuit 1' basé sur une architecture microprogrammée et composé de plusieurs sous-ensembles 3, 4, 5, 6, 6' coopérants de composants numériques comprenant essentiellement un micro-séquenceur 3 formant compteur, une mémoire 4 de stockage de microinstructions et une unité de traitement 5 associée à au moins une mémoire de travail (6, 6') et intégrant des modules 7, 7' de calcul arithmétique, et ladite unité de traitement 5 est apte et destinée à modifier les données des signaux de consigne numériques originels en prenant en compte les facteurs ou coefficients de correction ou de compensation fournis et en accord avec les microinstructions adressées par le micro-séquenceur 3 dans la mémoire de stockage 4 et qui forment un algorithme de correction pilotant le fonctionnement des différents sous-ensembles opérationnels 3, 5, 6, 6' constitutifs du dispositif de correction 1 et programmé en fonction de la correction à réaliser.

Selon une première caractéristique de l'invention, le séquencement des données au niveau de registres d'entrée 8 et de sortie 8' dudit dispositif 1, ainsi que la remise à zéro du micro-séquenceur 3 sont pilotés par un signal de synchronisation SYNC dont la période est un multiple du signal d'horloge CLK cadençant le fonctionnement des différents sous-ensembles constitutifs.

De plus, les modules de calcul arithmétiques sont préférentiellement constitués de pipelines (lignes de transmission arrangées en étages).

Selon une autre caractéristique de l'invention, la ou les mémoire(s) de travail 6, 6' comprend(nent) au moins une première zone mémoire 6 destinée à stocker les coefficients de correction à appliquer et au moins une seconde zone mémoire 6' destinée à stocker la donnée d'entrée à corriger, le ou les résultat(s) intermédiaire(s) des opérations arithmétiques réalisées par les modules de calculs arithmétiques et le résultat final correspondant à la donnée de sortie corrigée, ainsi que, le cas échéant, une ou des donnée(s) d'entrée précédente(s).

Il peut être prévu soit une seule mémoire de travail comprenant au moins deux zones de stockage 6 et 6' distinctes, soit deux mémoires de travail 6 et 6' distinctes.

Conformément à une caractéristique additionnel de l'invention, ladite au moins une seconde zone mémoire 6' est également apte et destinée à stocker la ou les donnée(s) de sortie d'au moins un signal de consigne corrigé produit lors d'au moins un cycle de correction antérieur, par exemple le signal de consigne corrigé du cycle précédent, et en ce que le signal de consigne corrigé courant résulte d'une opération de convolution réalisée par l'intermédiaire des modules de calcul 7, 7'.

L'arrangement et l'interconnexion des différents sous-ensembles, en particulier des mémoires 6, 6' et des modules de calcul 7, 7', autorisent ainsi un mode de fonctionnement récursif du dispositif 1.

La prévision de mémoires de stockage 4 et de travail 6, 6' comme exposée ci-dessus confère au dispositif 1 une grande souplesse. En effet, elles permettent d'effectuer :

- la mise à jour des coefficients ou facteurs de correction en temps réel (contenu de la mémoire 6),
- la modification du type d'opérations réalisées par le correcteur 1 par la mise à jour du micro-programme (contenu de la mémoire 4) sans modification de la structure de base du correcteur 1 (unités arithmétiques, etc).

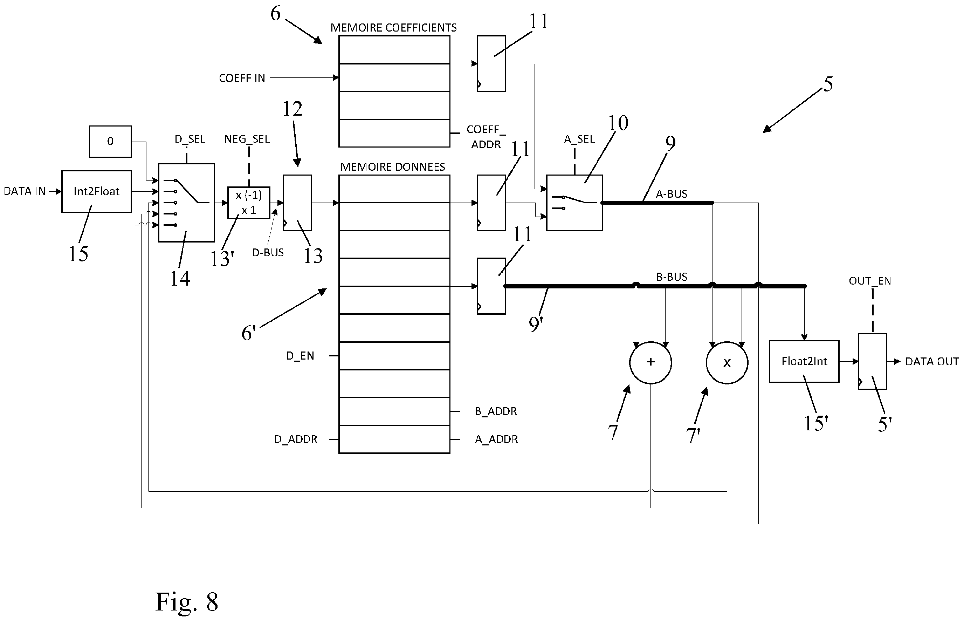

En accord avec une réalisation pratique avantageuse de l'invention, et comme l'illustre la figure 8 des dessins annexés, l'unité de traitement 5 comprend également, d'une part, des bus 9, 9' de transmission d'opérandes, éventuellement associés à au moins un multiplexeur 10 alimentant les modules de calcul arithmétique 7, 7', en fonction de signaux de commande élémentaires des microinstructions à exécuter, avec des données et des coefficients extraits de la ou des mémoire(s) de travail 6, 6' par l'intermédiaire de ports de lecture 11 et, d'autre part, au moins un bus 12 d'alimentation en données relié à un port d'écriture 13 de la seconde mémoire ou zone mémoire 6' et éventuellement à un module 13' d'inversion de signe, et associé en amont à un multiplexeur 14 relié aux sorties des modules de calcul arithmétique 7, 7', au registre d'entrée 8 de la donnée à corriger, le cas échéant à au moins l'un des bus 9, 9' de transmission d'opérandes, et éventuellement à un registre de mise à zéro, l'état dudit multiplexeur 14 étant également déterminé par des signaux de commande élémentaires des microinstructions à exécuter.

Lorsque le format des données numériques manipulées par l'unité de traitement 5 et stockées dans les mémoires de travail 6, 6' est différent de celui ou ceux du ou des formats des données numériques en entrée (DATA-IN) ou en sortie (DATA-OUT), il peut être prévu que le dispositif 1 comprenne aussi des modules de conversion 15, 15' mutuellement inverses, en entrée et en sortie, les données d'entrée et de sortie étant par exemple des nombres entiers codés en complément à deux (fig. 6).

En accord avec un mode de réalisation très préféré de l'invention, les deux modules de conversion 15 et 15' consistent respectivement en un module de conversion de nombres entiers en des nombres à virgule flottante en double précision sur 64 bits, préférentiellement selon la norme IEEE 754, et en un module de conversion inverse similaire.Le dispositif de correction ou correcteur 1 peut, par conséquent, être aisément inséré ou intercalé dans un système de génération de gradient, sans modification de la nature des signaux délivrés (le signal de consigne modifié ainsi que le signal de consigne originel restent sous forme numérique) et sans perturber le flux desdits signaux (correction en temps réel, le système de correction introduisant un retard minimal compatible avec l'application), ce tout en transposant les données des signaux de consigne numériques en un format facilitant la précision de leur traitement correctif.

Bien que l'invention soit décrite et représentée plus particulièrement dans le cadre d'une structure linéaire, l'homme du métier comprend aisément qu'en cas de voies multiples ou de quantités de données à traiter importantes, le dispositif de correction 1 peut présenter une structure vectorielle et comporter plusieurs circuits 1' arrangés en parallèle, chaque circuit intégrant un groupement fonctionnel [micro-séquenceur 3 / mémoire de stockage 4 / unité de traitement 5 et mémoire(s) de travail 6, 6'].

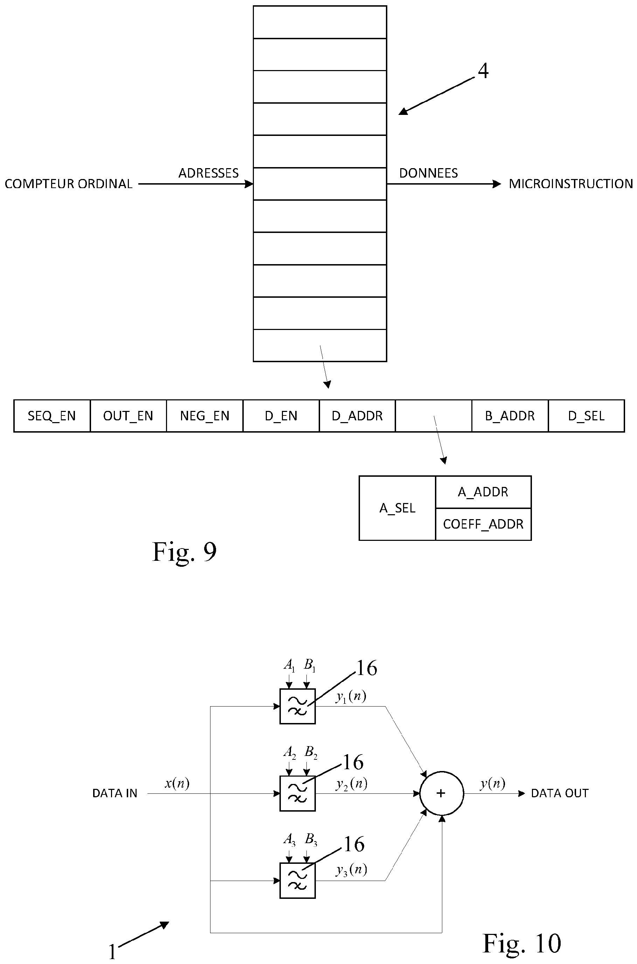

Conformément à une application possible de l'invention, ressortant de la figure 10, le dispositif 1 peut être programmé pour implémenter trois cellules de filtrage 16 arrangées en parallèle, chaque cellule correspondant préférentiellement à un filtre numérique passe-haut du premier ordre.

Le dispositif de correction 1 présente une grande souplesse d'utilisation et peut servir à effectuer divers types d'opérations sur le signal à corriger, par exemple un signal de consigne d'amplificateur. Par conséquent, il peut, par exemple, également être utilisé pour corriger les défauts de linéarité de l'amplificateur de gradients 19' dans une application en relation avec un système 17 de génération de gradients de champ magnétique.

L'invention concerne également un système 17 du type précité, qui comprend essentiellement, comme le montre la figure 5 des dessins annexés, des moyens 18, 18' de génération d'un signal de consigne numérique, par exemple sous la forme d'une séquence d'impulsions, des moyens de conversion 19 et d'amplification 19' du signal de consigne et une ou plusieurs bobine(s) 2 de génération de gradients alimentée(s) par le signal ou les signaux amplifiée(s) fourni(s) par les moyens de conversion et d'amplification associés, le cas échéant respectivement correspondante, ledit système comportant également un dispositif de correction du signal de consigne avant sa conversion analogique et son amplification, et le cas échéant sa démultiplication.

Ce système 17 est caractérisé en ce que le dispositif de correction est un dispositif 1 tel que décrit précédemment.

Ce système 17 peut avantageusement consister en un système de génération de gradients selon plusieurs axes, un dispositif de correction 1 étant associé à chaque axe.

Enfin, l'invention porte également sur un procédé de correction en temps réel de signaux variables de consigne ou de commande de bobines de gradients d'un appareil de spectrométrie ou d'imagerie par résonance magnétique nucléaire en fonction de facteurs ou de coefficients de correction ou de compensation fournis, ce procédé mettant en oeuvre au moins un dispositif de correction tel que décrit ci-dessus.

Ce procédé est caractérisé en ce qu'il consiste essentiellement, au niveau du ou de chaque dispositif 1 de correction, à convertir les données numériques successives formant ensemble un signal de consigne originel pour bobine(s) de gradient en des données adaptées pour un traitement par l'unité 5, à traiter lesdites données converties, en des boucles opératoires successives, par l'intermédiaire des modules de calcul arithmétique 7, 7' en fonction des microinstructions présentes dans la mémoire de stockage 4 et formant un algorithme de correction, en tenant compte des coefficients de correction présents dans la ou les mémoire(s) de travail 6, 6' et en stockant les résultats intermédiaires, ainsi que les données résultant du traitement correctif également dans la ou les mémoires de travail, et, à convertir les données résultant du traitement correctif en des données d'un format identique à celui des données du signal de consigne originel et formant une partie d'un signal de consigne corrigé.

Préférentiellement, le traitement des données par l'unité 5 comprend au moins une opération de convolution, au moins les données du signal de consigne corrigé calculées durant le cycle antérieur étant prises en compte.L'invention sera décrite dans ce qui suit, à titre d'exemple, de manière plus détaillée et en relation avec les dessins annexés.

La figure 6 illustre les différentes parties constitutives essentielles du dispositif de correction 1, à savoir :

- le micro-séquenceur 3 qui est un compteur permettant l'incrémentation du pointeur, ou compteur ordinal, de microcode exécuté,
- l'unité de traitement 5 qui est composée des unités ou modules de calcul de base 7, 7' ainsi que des multiplexeurs 10, 14 permettant le transfert des données,
- la mémoire 6 de coefficients de correction déterminés pour l'application courante,
- la mémoire 6' de données qui contient les résultats intermédiaires, ou finaux, des calculs effectués par l'unité de traitement 5,
- la mémoire microcode 4 qui contient le microcode constituant le microprogramme. Chaque ligne de microcode, qui est une micro instruction, peut éventuellement piloter le micro-séquenceur 3, la mémoire de données 6' et de coefficients 6 (ou éventuellement la mémoire unique partitionnée en zones contenant respectivement les données et les coefficients) et l'unité de traitement 5.

Les données en entrée du correcteur 1 sont avantageusement des nombres entiers codés en complément à deux et les données en sortie sont également des nombres entiers codés en complément à deux, les données effectivement traitées dans le correcteur 1 étant dans un format différent, par exemple en nombre à virgule flottante, plus adapté au traitement envisagé.

Toutes les composantes du dispositif de correction 1 fonctionnent de manière synchrone à l'aide d'une seule horloge (signal CLK sur la figure 6). Le flot de données en entrée et en sortie du dispositif 1 (CORRECTOR_IN et CORRECTOR_OUT) est également synchronisé avec cette horloge.

Les registres de données 8 et 8', tels que représentés sur la figure 6, sont rafraîchis en fonction d'un signal de synchronisation (SYNC) dont la période correspond à un nombre entier et constant de périodes d'horloge CLK. Le temps d'activation du signal de synchronisation est égal à une période d'horloge. Le délai entre les données en entrée et les données corrigées en sortie correspond à la période du signal de synchronisation. Le démarrage du micro-séquenceur 3 est aussi conditionné par ce signal de synchronisation.

Le micro-séquenceur 3 est composé d'un compteur piloté par des signaux du dispositif (voir figures 6 et 7). La sortie (OUT) du micro-séquenceur 3 correspond à la valeur courante du compteur.

Les signaux de pilotage dudit micro-séquenceur 3 sont les suivants :

- RST : entrée d'initialisation asynchrone. Celle-ci est prioritaire sur les autres entrées. Lorsqu'activée, le micro-séquenceur 3 se réinitialise, c'est-à-dire sa sortie se positionne à l'état initial (zéro par exemple). Cette entrée est utilisée lors de l'initialisation globale du correcteur, à la mise sous tension par exemple.
- CLK : entrée d'horloge.
- EN : entrée (synchrone) de validation. La sortie du compteur est incrémentée, par pas de un, à chaque période d'horloge, tant que cette entrée est validée.
- RESTART : entrée (synchrone) de redémarrage. Le micro-séquenceur 3 est réinitialisé lorsque cette entrée est activée. Cette entrée est prioritaire sur l'entrée EN. En d'autres termes, si le micro-séquenceur 3 est désactivé car l'entrée EN est inactive, l'activation de RESTART réinitialise tout de même le micro-séquenceur 3.

La sortie du micro-séquenceur 3 adresse la mémoire 4 contenant le microcode. La valeur courante du compteur correspond par conséquent au compteur ordinal. L'entrée d'horloge (CLK) du micro-séquenceur 3 est connectée à l'horloge globale du dispositif de correction 1. L'entrée de validation (EN) est contrôlée par le microcode, via le signal SEQ_EN, tandis que l'entrée de redémarrage est connectée au signal de synchronisation du dispositif (SYNC sur la figure 6). Le compteur ordinal peut donc être arrêté par le microcode lorsque les calculs ont été effectués, puis être redémarré (rappelons que l'entrée RESTART est prioritaire sur EN) par le signal de synchronisation afin d'effectuer les calculs sur les données suivantes.

L'unité de traitement 5 a été conçue de manière à utiliser un minimum de ressources matérielles tout en garantissant des performances optimales. Les critères de performances concernent non seulement le temps de calcul mais également la précision de ces derniers. La notion de précision des calculs est primordiale si le correcteur 1 doit implémenter des filtres numériques à réponse impulsionnelle infinie (RII) d'ordre supérieur ou égal à 2 (les erreurs dues aux arrondis peuvent alors entraîner l'instabilité du filtre).

Afin de garantir une bonne précision, l'unité de traitement 5 effectue avantageusement les calculs avec des nombres en virgule flottante respectant la norme IEEE 754 (ou CEI 60559). Une précision moindre peut suffire suivant les cas d'utilisation, des nombres en virgule fixe peuvent alors être employés afin d'économiser des ressources. Le principe de fonctionnement resterait tout de même identique.

Les données en entrée et en sortie (DATA_IN et DATA_OUT) sont des nombres entiers codés en complément à deux. En entrée ces données sont converties en nombres à virgule flottante (convertisseur 15 = bloc "Int2Float") et en sortie les données sont converties en nombres entiers (convertisseur 15' = bloc "Float2Int").

La mémoire de données 6', volatile (de type RAM), autorise préférentiellement trois accès simultanés aux données stockées: deux accès en lecture et un accès en écriture, ceci à trois adresses différentes.

La mémoire des coefficients 6, volatile également, est caractérisée par des ports d'écriture et de lecture 11 séparés, le port d'écriture étant connecté sur un bus provenant d'un dispositif extérieur au correcteur 10 (voir figure 5).

La largeur d'une ligne de mémoire (données ou coefficients) correspond, dans la pratique, à la taille des nombres en virgule flottante (par exemple 64 bits s'il s'agit d'un format de codage « double précision » suivant la norme IEEE 754, ou 32 bits dans le cas du codage en « simple précision »). Les profondeurs des mémoires données 6' et coefficients 6 dépendent du type d'algorithme de correction mis en oeuvre.

L'un des ports de lecture 11 de la mémoire de données 6' et le port de lecture 11 de la mémoire des coefficients 6 sont connectés sur un bus 9 d'opérandes (A-BUS). La source de l'opérande se trouvant sur A-BUS est sélectionnée via un multiplexeur 10. En d'autres termes, l'opérande se trouvant sur A-BUS peut être un résultat stocké (source :

mémoire des données 6') ou un coefficient (source : mémoire des coefficients 6) suivant l'état du multiplexeur 10. Le second bus 9' d'opérandes (B-BUS) est directement connecté sur l'autre port de lecture 11 de la mémoire des données 6'.

Les bus d'opérandes 9 (A-BUS) et 9' (B-BUS) alimentent des unités ou modules arithmétiques 7, 7' pour nombres à virgule flottante : un additionneur 7 et un multiplieur 7'. B-BUS permet également d'envoyer les données vers le convertisseur 15' [nombre à virgule flottante / nombre entier].

Sur le port d'écriture 13 de la mémoire de données est connecté un bus 12, dénommé D-BUS. Sur ce dernier est placé un multiplexeur 14 permettant de sélectionner la source de la donnée à stocker. Cette source peut-être :

- un registre contenant la valeur 0, ceci permet d'initialiser une ligne mémoire,
- le résultat de la conversion nombre entier vers nombre à virgule flottante (sortie du convertisseur 15). La donnée d'entrée peut ainsi être stockée en mémoire de données 6',
- le résultat de la multiplication des opérandes des bus A-BUS et B-BUS (bus 9 et 9'),
- le résultat de l'addition des opérandes des bus A-BUS et B-BUS (bus 9 et 9'),

L'opérande se trouvant sur le bus 9 (A-BUS), ceci permet de déplacer des données en mémoire de données 6'.

Avant d'être placée en mémoire de données, le signe d'une valeur peut éventuellement être changé (au niveau du module d'inversion 13') afin de stocker son opposé.

On notera que la largeur de tous les bus 9, 9', 12 mentionnés correspond à la taille des nombres en virgule flottante.

Sans modifier le principe de fonctionnement du dispositif 1, des registres tampons peuvent être placés sur les ports d'accès des mémoires 6, 6' afin d'augmenter la fréquence de fonctionnement de l'unité de traitement 5. Ceci équivaut à ajouter des étages de pipeline. Le fonctionnement des unités ou modules 7 et 7' effectuant les opérations arithmétiques (additionneur et multiplieur) peut également reposer sur des lignes de transmission. Le nombre d'étages nécessaires est dépendant de la fréquence de fonctionnement et de la technologie mise en oeuvre.

En outre, afin d'accélérer les calculs, le traitement peut aisément être vectorisé. A cette fin plusieurs sous-ensembles [unités de traitement 5/mémoire 6, 6' de données et de coefficients] peuvent être placés en parallèle tout en étant pilotés par le même microcode.

Le fonctionnement coopératif et coordonné des composantes de l'unité de traitement 5 et des mémoires 6, 6' des données et des coefficients est conditionné par des signaux de commandes qui correspondent à des champs contenus dans les microinstructions.

Les signaux de commande sont les suivants pour l'exemple représenté figure 8 :

- D_SEL : sélection de la source des données à placer sur D-BUS (bus 12).
- NEG_SEL : signal d'activation de l'unité 5 permettant d'inverser le signe de la donnée présente sur D-BUS.
- D_ADDR: adresse d'écriture des données dans la mémoire des données 6'.
- D_EN : signal de validation du port d'écriture 13 de la mémoire des données 6'. Lorsque ce signal est actif la donnée présente sur D-BUS (bus 12) est stockée dans la mémoire des données 6' à l'adresse indiquée par D_ADDR (bus 9).
- A_ADDR: adresse de lecture des données dans la mémoire des données 6' pour le premier port de lecture 11.
- B_ADDR: idem à A_ADDR, pour le second port de lecture 11 de la mémoire des données 6'.
- COEFF_ADDR: adresse de lecture des données dans la mémoire des coefficients 6.
- A_SEL : sélection de la source des données à placer sur A-BUS (bus 9).
- OUT_EN : signal de validation du registre contenant le résultat de l'unité de conversion 8' [nombres à virgule flottante vers nombres entiers]. Cette donnée correspond au résultat final calculé par l'unité de traitement 5.

La mémoire microcode 4 (mémoire de stockage des microinstructions) est non volatile et possède un port d'accès unique. Chaque ligne de cette mémoire 4 contient une microinstruction. Son bus d'adresses est connecté au compteur ordinal, qui correspond à la sortie du micro-séquenceur 4, tandis que son bus données véhicule les microinstructions. La taille de la mémoire 4 dépend du type d'algorithme de correction mis en oeuvre : le nombre de lignes est fonction de la quantité de microinstructions à exécuter et la taille d'une ligne est en rapport avec la quantité d'emplacements de mémoire de données et de coefficients à adresser.

Cette mémoire microcode peut être volatile s'il s 'avère nécessaire d'améliorer la souplesse du dispositif de correction 1 en changeant le type d'algorithme. Ceci n'a pas d'influence sur le principe de fonctionnement dudit correcteur 1.

Dans l'exemple représenté figure 9, chaque microinstruction est codée sous forme de champs fixes, chaque champ contenant un signal de commande. Les signaux de commande sont ceux énumérés dans la section précédente auxquels s'ajoute le signal de validation du micro-séquenceur 4 (SEQ_EN). Les signaux A_SEL, A ADDR et COEFF_ADDR sont combinés en un champ unique. La taille de ce champ correspond à la taille du bus d'adresses le plus grand entre A ADDR et COEFF _ADDR, plus un bit pour A_SEL. En effet, par le bus d'opérandes A-BUS (bus 9) ne transite qu'une donnée à la fois, qui provient soit de la mémoire des données 6', soit de la mémoire des coefficients 6.

Dans ce qui suit, on décrira plus en détail un exemple non limitatif d'implémentation d'une fonction par le dispositif de correction ou correcteur 1.

L'exemple décrit ci-après présente l'utilisation du correcteur 1 dans un système 17 de génération de gradients équipé d'un seul axe, donc d'une seule bobine de gradient 2 et d'un seul amplificateur de courant 19' (tel que représenté figure 5).

Plus précisément, le correcteur 1 implémente trois cellules de filtrage 16 en parallèle dans l'exemple décrit (voir figure 10).

Chaque cellule 16 correspond à un filtre numérique passe-haut du premier ordre. Cette configuration permet d'agir sur six paramètres (le gain et la constante de temps de chaque cellule 16) du correcteur 1 afin d'obtenir le meilleur champ de gradients possible.

La fonction de transfert d'une cellule de filtrage 16 peut être déterminée comme suit :

1) Fonction de transfert dans le plan de Laplace d'un filtre passe-haut du premier ordre :

$$H(s) = k\frac{\tau s}{\tau s + 1}$$

Avec :

$k$ le gain
$\tau$ la constante de temps

2) Fonction de transfert dans le plan z, transformation bilinéaire :

$$s = 2f\frac{1 - z^{-1}}{1 + z^{-1}}$$

Avec :
$f$ la fréquence d'échantillonnage, qui dans le cadre du correcteur 1 correspond à la fréquence du signal de synchronisation SYNC (voir figure 6).

3) Fonction de transfert dans le plan z:

$$H(z^{-1}) = A\frac{1 - z^{-1}}{1 + Bz^{-1}} \tag{1}$$

Avec :

$$A = k\frac{2f\tau}{1 + 2f\tau} \tag{2}$$

$$B = k\frac{1 - 2f\tau}{1 + 2f\tau} \tag{3}$$

4) Transposition de la relation (1) dans le domaine temporel :

$$y(n) = A(x(n) - x(n-1)) - By(n-1) \tag{4}$$

5) Fonction de transfert dans le domaine temporel du correcteur 1 représenté sur la figure 10 est :

$$y(n) = x(n) + y_1(n) + y_2(n) + y_3(n) \qquad (5)$$

En utilisant la relation (4) avec (5), nous obtenons :

$$y(n) = x(n) + A_1(x(n) - x(n-1)) - B_1y_1(n-1) + A_2(x(n) - x(n-1)) -$$
$$B_2y_2(n-1) + A_3(x(n) - x(n-1)) - B_3y_3(n-1)$$

Chaque couple de coefficients $(A_m;B_m)$ est calculé à l'aide des relations (2) et (3) en prenant en considération le gain $\kappa_m$ et la constante de temps $\tau_m$ de chaque cellule 16 qui, dans l'exemple décrit, sont les paramètres d'entrée du système 17.

Les termes $A_1,A_2,A_3,B_1,B_2,B_3$ peuvent être identifiés aux coefficients du correcteur 1. Le calcul de ces termes en fonction des gains et constantes ne présente pas d'aspect temps réel. Ce calcul peut par conséquent être effectué par un dispositif externe ne faisant pas partie du correcteur 1 (unité de calcul sur la figure 5) et ne nécessite pas de description supplémentaire, compte tenu des connaissances de l'homme du métier.

Dans le cas où les paramètres d'entrée du système sont les gains et constantes de temps des trois cellules 16 dans le domaine analogique, le dispositif externe devra lors du calcul des coefficients compenser la déformation en fréquence apportée par la transformation bilinéaire.

Dans le cadre de l'exemple pratique décrit, il y a ensuite lieu de réaliser l'implémentation de l'algorithme de correction.

Pour implémenter cet algorithme, il y a lieu de considérer que les composantes du correcteur 1 ont les caractéristiques suivantes :

-  Valeur initiale du compteur ordinal : 0.
-  Calculs sur des nombres à virgule flottante de précision étendue selon la norme IEEE 754 (64 bits dont 1 bit de signe, 11 bits d'exposant et 52 bits de mantisse).
-  Pas de traitement vectorisé : le correcteur 1 est composé d'un seul sous-ensemble [unité de traitement 5/mémoires de données et coefficients 6, 6'].
-  Nombre d'étages de pipelines constituant les unités de calcul pour nombres à virgule flottante :

    Multiplieur : cinq étages de canaux de communication (pipeline)
    Additionneur : sept étages de canaux de communication (pipeline)

-  Ports d'accès en lecture des mémoires 4, 6, 6' équipés de registres tampons : latence d'une période d'horloge lors d'un accès.
-  Convertisseurs de format des nombres 15, 15' et unité d'inversion de signe 13' sans étage de pipeline (canaux de communication).
-  Codes de sélection du multiplexeur 14 alimentant D-BUS (bus 12) :

    000 : registre contenant 0
    001 : sortie du convertisseur 15 nombres entiers vers nombres à virgule flottante
    010 : résultat en sortie du multiplieur 7'
    011 : résultat en sortie de l'additionneur 7
    100 : donnée présente sur A-BUS (bus 9)

-  Codes de sélection du multiplexeur 10 alimentant A-BUS (bus 9) :

    0 : premier port de lecture 11 de la mémoire de données 6'
    1 : port de lecture 11 de la mémoire des coefficients 6

-  Structure des microinstructions : Une microinstruction est codée sur 20 bits, les champs sont les suivants :

    SEQ_EN : 1 bit

    OUT_EN : 1 bit

NEG_EN : 1 bit

D_EN : 1 bit

D_ADDR: 4 bits

A_SEL : 1 bit

A_ADDR/COEFF_ADDR: 4 bits

B_ADDR: 4 bits

D_SEL : 3 bits

- Taille de la mémoire microcode 4 : 61 x 20 bits

- Taille de la mémoire des données 6 : 12 x 64 bits

- Taille de la mémoire des coefficients 6 : 6 x 64 bits

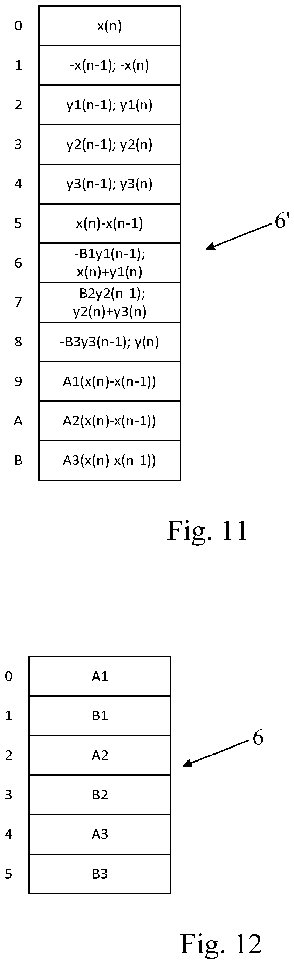

Les figures 11 et 12 montrent le contenu des mémoires de données 6' et des coefficients 6. La notation des adresses est hexadécimale. Afin de diminuer la quantité de mémoire de données nécessaire, une même ligne peut contenir des données différentes en fonction de l'évolution de l'exécution de l'algorithme : l'adresse 8 par exemple contient d'abord le résultat de la multiplication de $B_2$ par $y_2(n - 1)$ puis le résultat final $y(n)$.

Le tableau suivant comprend les opérations successives correspondant à l'algorithme de l'exemple décrit (chaque ligne du tableau correspond à une microinstruction donc à une ligne de la mémoire microcode).

| Ligne | Description de l'opération |
|---|---|
|  |  |
| 0 | Stockage de x(n); lecture de B1 et y1(n-1) |
| 1 | Lecture de B2 et y2(n-1) |
| 2 | Lecture de x(n) et -x(n-1) |
| 3 | Pas d'opération |
| 4 | Remplacement de -x(n-1) par x(n); lecture de B3 et y3(n-1) |
| 5 | Pas d'opération |
| 6 | Pas d'opération |
| 7 | Stockage de -B1y1(n-1) |
| 8 | Stockage de -B2y2(n-1) |
| 9 | Pas d'opération |
| 10 | Stockage de x(n)-x(n-1) |
| 11 | Stockage de -B3y3(n-1) |
| 12 | Lecture de A1 et x(n)-x(n-1) |
| 13 | Lecture de A2 et x(n)-x(n-1) |
| 14 | Lecture de A3 et x(n)-x(n-1) |
| 15 | Pas d'opération |
| 16 | Pas d'opération |
| 17 | Pas d'opération |
| 18 | Pas d'opération |

(suite)

| Ligne | Description de l'opération |
|-------|---------------------------|
| 19 | Stockage de A1 (x(n)-x(n-1)) |
| 20 | Stockage de A2(x(n)-x(n-1)) |
| 21 | Stockage de A3(x(n)-x(n-1)) |
| 22 | Lecture de A1(x(n)-x(n-1)) et -B1y1(n-1) |
| 23 | Lecture de A2(x(n)-x(n-1)) et -B2y2(n-1) |
| 24 | Lecture de A3(x(n)-x(n-1)) et -B3y3(n-1) |
| 25 | Pas d'opération |
| 26 | Pas d'opération |
| 27 | Pas d'opération |
| 28 | Pas d'opération |
| 29 | Pas d'opération |
| 30 | Pas d'opération |
| 31 | Stockage de y1(n) |
| 32 | Stockage de y2(n) |
| 33 | Stockage de y3(n); lecture de x(n) et y1(n) |
| 34 | Pas d'opération |
| 35 | Lecture de y2(n) et y3(n) |
| 36 | Pas d'opération |
| 37 | Pas d'opération |
| 38 | Pas d'opération |
| 39 | Pas d'opération |
| 40 | Pas d'opération |
| 41 | Pas d'opération |
| 42 | Stockage de x(n)+y1(n) |
| 43 | Pas d'opération |
| 44 | Stockage de y2(n)+y3(n) |
| 45 | Pas d'opération |
| 46 | Lecture de x(n)+y1(n) et y2(n)+y3(n) |
| 47 | Pas d'opération |
| 48 | Pas d'opération |
| 49 | Pas d'opération |
| 50 | Pas d'opération |
| 51 | Pas d'opération |
| 52 | Pas d'opération |
| 53 | Pas d'opération |
| 54 | Pas d'opération |
| 55 | Stockage de y(n) |
| 56 | Pas d'opération |

(suite)

| Ligne | Description de l'opération |
|-------|----------------------------|
| 57 | Lecture de y(n) |
| 58 | Pas d'opération |
| 59 | Activation du registre de sortie |
| 60 | Attente |

Comme variante de mise en oeuvre pratique du dispositif de correction selon l'invention (par rapport au filtre numérique passe-haut du premier ordre décrit en détail ci-dessus), il est également possible d'implémenter un filtre récursif du second ordre à réponse impulsionnelle infinie, dont la fonction de transfert dans le plan z s'établit comme suit :

$$H(z^{-1}) = \frac{b_0 + b_1 z^{-1} + b_2 z^{-2}}{1 + a_1 z^{-1} + a_2 z^{-2}}$$

Ce qui, dans le domaine temporel, conduit à la fonction suivante :

$$y(n) = b_0 x(n) + b_1 x(n-1) + b_2 x(n-2) - a_1 y(n-1) - a_2 y(n-2)$$

De la même manière que pour le filtre du premier ordre, les coefficients a et b sont stockés dans la mémoire 6 des coefficients, les échantillons x (entrée du filtre) et y (sortie du filtre) étant stockés dans la mémoire 6' de données.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

**Revendications**

1. Dispositif de correction numérique en temps réel de signaux variables de consigne ou de commande de bobines de gradients d'un appareil de spectrométrie ou d'imagerie par résonance magnétique nucléaire en fonction de facteurs ou de coefficients de correction ou de compensation fournis, ledit dispositif étant destiné à recevoir en entrée des signaux de consigne numériques originels et à délivrer à sa sortie des signaux de consigne numériques qui ont été modifiés pour compenser les défauts, limitations, perturbations, interférences, effets négatifs ou analogues rencontrés ultérieurement lors du traitement, de la transmission, de la transformation et/ou de l'application desdits signaux de consigne,
ce dispositif (1) consistant en au moins un circuit (1') basé sur une architecture microprogrammée et composé de plusieurs sous-ensembles opérationnels (3, 4, 5, 6, 6') coopérants de composants numériques comprenant un micro-séquenceur (3) formant compteur, une mémoire (4) de stockage de microinstructions et une unité de traitement (5) associée à au moins une mémoire de travail (6, 6') et intégrant des modules (7, 7') de calcul arithmétique, et, ladite unité de traitement (5) étant apte et destinée à modifier les données des signaux de consigne numériques originels en prenant en compte les facteurs ou coefficients de correction ou de compensation fournis et en accord avec les microinstructions adressées par le micro-séquenceur (3) dans la mémoire de stockage (4) et qui forment un algorithme de correction pilotant le fonctionnement des différents sous-ensembles opérationnels précités (3, 4, 5, 6, 6') constitutifs du dispositif de correction (1) et programmé en fonction de la correction à réaliser, ledit dispositif (1) étant **caractérisé en ce que** l'arrangement et l'interconnexion de la ou des mémoire(s) de travail (6, 6') et des modules de calcul (7, 7') autorisant un mode de fonctionnement récursif du dispositif de correction (1), avec réalisation d'au moins une opération de convolution par l'unité de traitement (5) en prenant en compte au moins la ou les donnée(s) du signal de consigne corrigé calculée(s) durant le cycle antérieur.

2. Dispositif selon la revendication 1, **caractérisé en ce qu'**il comprend des registres d'entrée (8) et de sortie (8'), **en ce que** le séquencement des données au niveau des registres d'entrée (8) et de sortie (8'), ainsi que la remise à zéro du micro-séquenceur (3) sont pilotés par un signal de synchronisation (SYNC) dont la période est un multiple du signal d'horloge (CLK) cadençant le fonctionnement des différents sous-ensembles opérationnels constitutifs (3, 4, 5, 6') et **en ce que** les modules de calcul arithmétiques (7, 7') sont constitués de pipelines.

3. Dispositif selon l'une quelconque des revendications 1 et 2, **caractérisé en ce que** la ou les mémoire(s) de travail (6, 6') comprend(nent) au moins une première zone mémoire (6) destinée à stocker les coefficients de correction à appliquer et au moins une seconde zone mémoire (6') destinée à stocker i) la donnée d'entrée à corriger, ii) le ou les résultat(s) intermédiaire(s) des opérations arithmétiques réalisées par les modules de calculs arithmétiques et iii) le résultat final desdites opérations arithmétiques, correspondant à une donnée de sortie corrigée, ainsi que, le cas échéant, iiii) une ou des donnée(s) d'entrée précédente(s).

4. Dispositif selon la revendication 3, **caractérisée en ce que** ladite au moins une seconde zone mémoire (6') est également apte et destinée à stocker la ou les donnée(s) de sortie d'au moins un signal de consigne corrigé produit lors d'au moins un cycle de correction antérieur, et **en ce que** le signal de consigne corrigé courant résulte d'une opération de convolution réalisée par l'intermédiaire des modules de calcul (7, 7').

5. Dispositif selon la revendication 2 et selon l'une quelconque des revendications 1 à 4, **caractérisé en ce que** l'unité de traitement (5) comprend également, d'une part, des bus (9, 9') de transmission d'opérandes, associés à au moins un multiplexeur (10) alimentant les modules de calcul arithmétique (7, 7'), en fonction de signaux de commande élémentaires des micro instructions à exécuter, avec des données et des coefficients extraits de la ou des mémoire(s) de travail (6, 6') par l'intermédiaire de ports de lecture (11) et, d'autre part, au moins un bus (12) d'alimentation en données relié à un port d'écriture (13) d'une autre ou seconde mémoire ou zone mémoire (6') et à un module (13') d'inversion de signe, et associé en amont à un multiplexeur (14) relié aux sorties des modules de calcul arithmétique (7, 7'), au registre d'entrée (8) de la donnée à corriger, le cas échéant à au moins l'un des bus (9, 9') de transmission d'opérandes, et à un registre de mise à zéro, l'état dudit multiplexeur (14) étant également déterminé par des signaux de commande élémentaires des microinstructions à exécuter.

6. Dispositif selon l'une quelconque des revendications 1 à 5, **caractérisé en ce qu'**il comprend aussi des modules de conversion (15, 15') de format numérique, mutuellement inverses, en entrée et en sortie.

7. Dispositif selon la revendication 6, **caractérisé en ce que** les deux modules de conversion (15 et 15') consistent respectivement en un module de conversion de nombres entiers en des nombres à virgule flottante en double précision sur 64 bits, et en un module de conversion inverse similaire.

8. Dispositif selon l'une quelconque des revendications 1 à 7, **caractérisé en ce que** qu'il présente une structure vectorielle et comporte plusieurs circuits (1') arrangés en parallèle, chaque circuit intégrant un groupement fonctionnel [microséquenceur (3) / mémoire de stockage (4) / unité de traitement (5) et mémoire(s) de travail (6, 6')].

9. Dispositif selon l'une quelconque des revendications 1 à 8, **caractérisé en ce qu'**il est programmé pour implémenter trois cellules de filtrage (16) arrangées en parallèle, chaque cellule correspondant à un filtre numérique passe-haut du premier ordre.

10. Système de génération de gradients de champ magnétique comprenant des moyens de génération d'un signal de consigne numérique, des moyens de conversion et d'amplification du signal de consigne et une ou plusieurs bobine(s) de génération de gradients alimentée(s) par le signal ou les signaux amplifiée(s) fourni(s) par les moyens de conversion et d'amplification associés, le cas échéant respectivement correspondants, ledit système comportant également un dispositif de correction du signal de consigne avant sa conversion analogique et son amplification, et le cas échéant sa démultiplication, système **caractérisé en ce que** le dispositif de correction est un dispositif (1) selon l'une quelconque des revendications 1 à 9.

11. Système selon la revendication 10, **caractérisé en ce qu'**il consiste en un système de génération de gradients selon plusieurs axes, un dispositif de correction (1) étant associé à chaque axe.

12. Procédé de correction numérique en temps réel de signaux variables de consigne ou de commande de bobines de gradients d'un appareil de spectrométrie ou d'imagerie par résonance magnétique nucléaire en fonction de facteurs ou de coefficients de correction ou de compensation fournis, ce procédé mettant en oeuvre, selon un mode de fonctionnement récursif, au moins un dispositif de correction selon l'une quelconque des revendications 1 à 9, comprenant des modules de conversion de format numérique, mutuellement inverses en entrée et en sortie, procédé **caractérisé en ce qu'**il consiste, au niveau du ou de chaque dispositif (1) de correction, à convertir les données numériques successives formant ensemble un signal de consigne originel pour bobine(s) de gradient en des données adaptées pour un traitement par l'unité (5), à traiter lesdites données converties, en des boucles opératoires successives, par l'intermédiaire des modules de calcul arithmétique (7, 7') en fonction des microinstructions présentes dans la mémoire de stockage (4) et formant un algorithme de correction, en tenant compte des coefficients de correction présents dans la ou les mémoire(s) de travail (6, 6') et en stockant les résultats intermédiaires, ainsi que les données résultant du traitement correctif également dans la ou les mémoires de travail, de telle manière que le traitement des données par l'unité (5) comprend au moins une opération de convolution, au moins les données du signal de consigne corrigé calculées durant le cycle antérieur étant prises en compte, et à convertir les données résultant du traitement correctif en des données d'un format identique à celui des données du signal de consigne originel et formant une partie d'un signal de consigne corrigé.

13. Procédé selon la revendication 12, **caractérisé en ce que** les données d'entrée et de sortie du dispositif de correction sont des nombres entiers codés en complément à deux.

**Patentansprüche**

1. Vorrichtung zur numerischen Korrektur veränderlicher Einstell- oder Befehlssignale von Gradientenspulen eines Spektrometrie- oder eines bildgebenden Gerätes durch magnetische Kernspinresonanz in Echtzeit in Abhängigkeit von gegebenen Korrektur- oder Kompensationsfaktoren oder -koeffizienten, wobei die genannte Vorrichtung dazu bestimmt ist, am Eingang ursprüngliche numerische Einstellsignale zu empfangen und an ihrem Ausgang numerische Einstellsignale auszugeben, die modifiziert wurden, um Fehler, Begrenzungen, Störungen, Interferenzen, negative Einflüsse oder dergleichen zu kompensieren, die später während der Verarbeitung, der Übertragung, der Wandlung und/oder der Anwendung der genannten Einstellsignale auftreten, wobei diese Vorrichtung (1) aus mindestens einem Schaltkreis (1') in mikroprogrammierter Architektur besteht, der sich aus mehreren zusammenwirkenden Arbeitsuntereinheiten (3, 4, 5, 6, 6') numerischer Komponenten zusammensetzt, einen Mikro-Sequenzer (3) umfassend, der einen Zähler bildet, einen Speicher (4) zur Speicherung von Mikrobefehlen und eine Verarbeitungseinheit (5), die mit mindestens einem Arbeitsspeicher (6, 6') verbunden ist und Arithmetik-Rechenmodule (7, 7') enthält, und

wobei die genannte Verarbeitungseinheit (5) geeignet und dazu bestimmt ist, die Daten der numerischen Einstellsignale unter Berücksichtigung der gegebenen Korrektur- oder Kompensationsfaktoren oder -koeffizienten und in Übereinstimmung mit den Mikroanweisungen zu modifizieren, die von dem Mikrosequenzer (3) im Speicher (4) adressiert werden und die einen Korrekturalgorithmus bilden, der die Arbeit der verschiedenen oben genannten Arbeitsuntereinheiten (3, 4, 5, 6, 6'), die die Korrekturvorrichtung (1) bilden, steuert und in Abhängigkeit von der vorzunehmenden Korrektur programmiert ist,
wobei die genannte Vorrichtung (1) **dadurch gekennzeichnet ist, dass** die Anordnung und Verknüpfung des oder der Arbeitsspeicher(s) (6, 6') und der Rechenmodule (7, 7') eine rekursive Arbeitsweise der Korrekturvorrichtung (1) unter Ausführung mindestens einer Faltungsoperation durch die Verarbeitungseinheit (5) unter Berücksichtigung mindestens der Daten des korrigierten Einstellsignals zulassen, die während des vorangehenden Zyklus berechnet wurden.

2. Vorrichtung nach Patentanspruch 1, **dadurch gekennzeichnet, dass** sie Eingangs- (8) und Ausgangsregister (8') enthält, dadurch, dass das Sequenzieren der Daten an den Eingangs- (8) und Ausgangsregistern (8'), sowie die Nullstellung der Mikro-Sequenzers (3), durch ein Synchronisationssignal (SYNC) getrieben werden, dessen Periode ein Vielfaches des Taktsignals (CLK) ist, das die Arbeit der verschiedenen Arbeitsuntereinheiten (3, 4, 5, 6, 6') taktet und dadurch, dass die Arithmetik-Rechenmodule (7, 7') aus Pipelines bestehen.

3. Vorrichtung nach irgendeinem der Patentansprüche 1 und 2, **dadurch gekennzeichnet, dass** der oder die Arbeitsspeicher (6, 6') mindestens einen ersten Speicherbereich (6) umfasst/umfassen, der dazu bestimmt ist, die anzuwendenden Korrekturkoeffizienten zu speichern und mindestens einen zweiten Speicherbereich (6'), der dazu bestimmt ist, i) das zu korrigierende Eingangsdatum, ii) das oder die Zwischenergebnis(se) der von den Arithmetik-Rechenmodulen ausgeführten arithmetischen Operationen und iii) das Endergebnis der genannten arithmetischen Operationen, das einem korrigierten Ausgabedatum entspricht, sowie gegebenenfalls iiii) ein vorangehendes Eingangsdatum oder mehrere vorangehende Eingangsdaten zu speichern.

4. Vorrichtung nach Patentanspruch 3, **dadurch gekennzeichnet, dass** der mindestens eine zweite Speicherbereich (6') ebenfalls in der Lage und dazu bestimmt ist, das Ausgabedatum oder die Ausgabedaten mindestens eines korrigierten Einstellsignals zu speichern, das in mindestens einem vorangehenden Korrekturzyklus erzeugt wurde, und dadurch, dass das laufende korrigierte Einstellsignal sich aus einer Faltungsoperation ergibt, die mit Hilfe der Rechenmodule (7, 7') ausgeführt wurde.

5. Vorrichtung nach Patentanspruch 2 und nach irgendeinem der Patentansprüche 1 bis 4, **dadurch gekennzeichnet, dass** die Verarbeitungseinheit (5) ebenfalls einerseits Busse (9, 9') zur Operandenübertragung umfasst, die mit mindestens einem Multiplexer (10) verbunden sind, die die Arithmetik-Rechenmodule (7, 7') in Abhängigkeit von elementaren Steuersignalen der auszuführenden Mikroanweisungen mit Daten und Koeffizienten versorgen, die dem oder den Arbeitsspeicher(n) (6, 6') über Leseanschlüsse (11) entnommen wurden, und andererseits mindestens einen Bus (12) zur Versorgung mit Daten, der mit einem Schreibanschluss (13) eines anderen oder zweiten Speichers oder Speicherbereichs (6') und mit einem Vozeicheninversionsmodul (13') und am Eingang mit einem Multiplexer (14) verbunden ist, der an die Ausgänge der Arithmetik-Rechenmodule (7, 7') angeschlossen ist, an das Eingangsregister (8) der zu korrigierenden Daten, gegebenenfalls an mindestens einen der Busse (9, 9') zur Operandenübertragung und an ein Nullstellregister, wobei der Zustand des genannten Multiplexers (14) ebenfalls durch elementare Steuersignale der auszuführenden Mikroanweisungen bestimmt wird.

6. Vorrichtung nach irgendeinem der Patentansprüche 1 bis 5, **dadurch gekennzeichnet, dass** sie ebenfalls zueinander inverse Konvertiermodule (15, 15') für numerische Formate am Eingang und Ausgang umfasst.

7. Vorrichtung nach Patentanspruch 6, **dadurch gekennzeichnet, dass** die beiden Konvertiermodule (15 und 15') aus einem Modul zum Konvertieren von ganzen Zahlen in Fließkommazahlen doppelter Genauigkeit von 64 Bit und aus einem entsprechend inversen Konvertiermodul bestehen.

8. Vorrichtung nach irgendeinem der Patentansprüche 1 bis 7, **dadurch gekennzeichnet, dass** sie eine Vektorstruktur hat und mehrere parallel angeordnete Schaltkreise (1') aufweist, wobei jeder Schaltkreis eine funktionelle Gruppe [Mikro-Sequenzer (3) / Speicher (4) / Verarbeitungseinheit (5) und Arbeitsspeicher (6, 6')] umfasst.

9. Vorrichtung nach irgendeinem der Patentansprüche 1 bis 8, **dadurch gekennzeichnet, dass** sie dafür programmiert ist, drei Filterzellen (16) zu implementieren, die parallel angeordnet sind, wobei jede Zelle einem digitalen Hochpassfilter erster Ordnung entspricht.

10. System zur Erzeugung von Magnetfeldgradienten, Mittel zur Erzeugung eines numerischen Einstellsignals umfassend, Mittel zur Konvertierung und Verstärkung des Einstellsignals und eine oder mehrere Spule(n) zur Gradientenerzeugung, die mit dem/den von den zugehörigen, gegebenenfalls jeweils entsprechenden Konvertierungs- und Verstärkungsmitteln erzeugten verstärkten Signal(en) versorgt wird/werden, wobei das genannte System ebenfalls eine Vorrichtung zur Korrektur des Einstellsignals vor dessen analoger Konvertierung und dessen Verstärkung und gegebenenfalls seiner Untersetzung aufweist, System, **dadurch gekennzeichnet, dass** die Korrekturvorrichtung eine Vorrichtung (1) nach irgendeinem der Patentansprüche 1 bis 9 ist.

11. System nach Patentanspruch 10, **dadurch gekennzeichnet, dass** es aus einem System zur Gradientenerzeugung längs mehrerer Achsen besteht, wobei jeder Achse eine Korrekturvorrichtung (1) zugeordnet ist.

12. Verfahren zur numerischen Korrektur veränderlicher Einstell- oder Befehlssignale von Gradientenspulen eines Spektrometrie- oder eines bildgebenden Gerätes durch magnetische Kernspinresonanz in Echtzeit in Abhängigkeit von gegebenen Korrektur- oder Kompensationsfaktoren oder -koeffizienten, wobei dieses Verfahren in rekursiver Arbeitsweise mindestens eine Korrekturvorrichtung nach irgendeinem der Patentansprüche 1 bis 9 verwendet, die zueinander inverse Konvertiermodule für numerische Formate am Eingang und Ausgang umfasst, Verfahren, **dadurch gekennzeichnet, dass** es in der oder jeder Korrekturvorrichtung (1) darin besteht, die aufeinanderfolgenden numerischen Daten, die zusammen ein ursprüngliches Einstellsignal für (eine) Gradientenspule(n) bilden, in für eine Verarbeitung durch die Einheit (5) geeignete Daten zu konvertieren, die genannten konvertierten Daten in aufeinanderfolgenden Arbeitsschleifen mittels der Arithmetik-Rechenmodule (7, 7') in Abhängigkeit von den Mikroanweisungen, die sich im Speicher (4) befinden und einen Korrekturalgorithmus bilden, und unter Berücksichtigung der Korrekturkoeffizienten, die sich in dem/den Arbeitsspeicher(n) (6, 6') befinden, und unter Speicherung der Zwischenergebnisse, sowie der Daten, die sich aus der Korrekturverarbeitung ergeben, ebenfalls in dem oder den Arbeitsspeicher(n), derart zu verarbeiten, dass die Datenverarbeitung durch die Einheit (5) mindestens eine Faltungsoperation umfasst, wobei mindestens die Daten des korrigierten Einstellsignals, das während des vorangehenden Zyklus berechnet wurde, berücksichtigt werden, und die sich aus der Korrekturverarbeitung ergebenden Daten in Daten zu konvertieren, deren Format mit dem der Daten des ursprünglichen Einstellsignals identisch ist, und die einen Teil eines korrigierten Einstellsignals bilden.

**13.** Verfahren nach Patentanspruch 12, **dadurch gekennzeichnet, dass** die Eingangs- und Ausgangsdaten der Korrekturvorrichtung in Zweierkomplement-Darstellung codierte Ganzzahlen sind.

**Claims**

**1.** Device for the digital real-time correction of variable setpoint or control signals for gradient coils of a nuclear magnetic resonance imaging or spectrometry apparatus on the basis of factors or coefficients of correction or of compensation that are supplied, said device being intended to receive, at input, original digital setpoint signals and to deliver, at its output, digital setpoint signals that have been modified so as to compensate for faults, limits, disturbances, interference, adverse effects or the like that are encountered subsequently during the processing, transmission, transformation and/or application of said setpoint signals,
this device (1) consisting of at least one circuit (1') based on a firmware architecture and formed of a plurality of interacting operational subassemblies (3, 4, 5, 6, 6') of digital components comprising a microsequencer (3) forming a counter, a memory (4) for storing microinstructions and a processing unit (5) associated with at least one working memory (6, 6') and incorporating arithmetic calculating modules (7, 7'), and
said processing unit (5) being able and intended to modify the data items from the original digital setpoint signals by taking account of the factors or coefficients of correction or of compensation that are supplied and in accordance with the microinstructions addressed by the microsequencer (3) in the storage memory (4) and that form a correction algorithm controlling the operation of the various aforementioned operational subassemblies (3, 4, 5, 6, 6') forming the correction device (1) and programmed on the basis of the correction to be performed,
said device (1) being **characterized in that** the layout and the interconnection of the working memory (ies) (6, 6') and of the calculating modules (7, 7') allow a recursive mode of operation of the correction device (1), with at least one convolution operation being carried out by the processing unit (5), taking account of at least the data item(s), from the corrected setpoint signal, calculated during the previous cycle.

**2.** Device according to Claim 1, **characterized in that** it comprises input (8) and output (8') registers, **in that** the sequencing of the data items at the input (8) and output (8') registers, as well as the resetting of the microsequencer (3) to zero, are controlled by a synchronization signal (SYNC) whose period is a multiple of the clock signal (CLK) clocking the operation of the various constituent operational subassemblies (3, 4, 5, 6, 6'), and **in that** the arithmetic calculating modules (7, 7') are formed of pipelines.

**3.** Device according to either one of Claims 1 and 2, **characterized in that** the working memory (ies) (6, 6') comprise(s) at least one first memory zone (6) intended to store the coefficients of correction to be applied, and at least one second memory zone (6') intended to store i) the input data item to be corrected, ii) the intermediate result(s) of the arithmetic operations carried out by the arithmetic calculating modules, and iii) the final result of said arithmetic operations, corresponding to a corrected output data item, and, where applicable, iiii) one or more previous input data item(s) .

**4.** Device according to Claim 3, **characterized in that** said at least one second memory zone (6') is also able and intended to store the output data item(s) from at least one corrected setpoint signal produced during at least one previous correction cycle, and **in that** the current corrected setpoint signal results from a convolution operation carried out by way of the calculating modules (7, 7').

**5.** Device according to Claim 2 and according to any one of Claims 1 to 4, **characterized in that** the processing unit (5) also comprises, firstly, operand transmission buses (9, 9') associated with at least one multiplexer (10) feeding the arithmetic calculating modules (7, 7'), on the basis of elementary control signals of the microinstructions to be executed, with data items and coefficients extracted from the working memory(ies) (6, 6') by way of read ports (11) and, secondly, at least one data item feed bus (12) linked to a write port (13) of another or second memory or memory zone (6') and to a sign reversal module (13') and associated, upstream, with a multiplexer (14) linked to the outputs of the arithmetic calculating modules (7, 7'), to the input register (8) of the data item to be corrected, where applicable to at least one of the operand transmission buses (9, 9'), and to a set to zero register, the state of said multiplexer (14) also being determined by elementary control signals of the microinstructions to be executed.

**6.** Device according to any one of Claims 1 to 5, **characterized in that** it also comprises mutually reverse digital-format conversion modules (15, 15') at input and at output.

**7.** Device according to Claim 6, **characterized in that** the two conversion modules (15 and 15') consist, respectively, of a module for converting integers into double-precision floating-point numbers on 64 bits, and a similar reverse conversion module.

8. Device according to any one of Claims 1 to 7, **characterized in that** it has a vector structure and includes a plurality of circuits (1') arranged in parallel, each circuit incorporating an operational group [microsequencer (3)/storage memory (4)/processing unit (5) and working memory(ies) (6, 6')].

9. Device according to any one of Claims 1 to 8, **characterized in that** it is programmed to implement three filter cells (16) arranged in parallel, each cell corresponding to a first-order high-pass digital filter.

10. System for generating magnetic field gradients, comprising means for generating a digital setpoint signal, means for converting and amplifying the setpoint signal and one or more gradient-generating coil (s) fed with the amplified signal(s) supplied by the associated and where applicable respectively corresponding conversion and amplification means, said system also including a device for correcting the setpoint signal before the analogue conversion thereof and the amplification thereof, and where applicable the scaling thereof, which system is **characterized in that** the correction device is a device (1) according to any one of Claims 1 to 9.

11. System according to Claim 10, **characterized in that** it consists of a system for generating gradients along a plurality of axes, a correction device (1) being associated with each axis.

12. Method for the digital real-time correction of variable setpoint or control signals for gradient coils of a nuclear magnetic resonance imaging or spectrometry apparatus on the basis of factors or coefficients of correction or of compensation that are supplied,
this method implementing, in a recursive mode of operation, at least one correction device according to any one of Claims 1 to 9, comprising mutually reverse digital-format conversion modules at input and at output,
which method is **characterized in that** it consists, at the or at each correction device (1), in converting the successive digital data items together forming an original setpoint signal for gradient coil(s) into data items suitable for processing by the unit (5), in processing said converted data items, in successive operating loops, by way of the arithmetic calculating modules (7, 7') on the basis of the microinstructions present in the storage memory (4) and forming a correction algorithm, by taking account of the coefficients of correction present in the working memory(ies) (6, 6') and by storing the intermediate results, along with the data items resulting from the corrective processing also in the working memory(ies), such that the processing of the data items by the unit (5) comprises at least one convolution operation, at least the data items from the corrected setpoint signal and calculated during the previous cycle being taken into account, and in converting the data items resulting from the corrective processing into data items in a format identical to that of the data items from the original setpoint signal and forming part of a corrected setpoint signal.

13. Method according to Claim 12, **characterized in that** the input and output data items of the correction device are two's complement-encoded integers.

18

PROGRAMME → SEQUENCEUR →

CONVERSION NUMERIQUE-ANALOGIQUE U AMPLIFICATEUR DE COURANT I BOBINE DE GRADIENTS

17

19 19' 2

## Fig. 1

18 18'

PROGRAMME → SEQUENCEUR

CONVERSION NUMERIQUE-ANALOGIQUE U AMPLIFICATEUR DE COURANT I BOBINE DE GRADIENTS AXE X

CONVERSION NUMERIQUE-ANALOGIQUE U AMPLIFICATEUR DE COURANT I BOBINE DE GRADIENTS AXE Y

CONVERSION NUMERIQUE-ANALOGIQUE U AMPLIFICATEUR DE COURANT I BOBINE DE GRADIENTS AXE Z

17

19 19' 2

## Fig. 2

Fig. 3

Fig. 4

Fig. 5

3

SEQ_EN

SYNC → MICRO-SEQUENCEUR → COMPTEUR ORDINAL

CLK

MICROINSTRUCTIONS (COMMANDES)

COEFFICIENTS

5, 6, 6', 7, 7'

4

MEMOIRE MICROCODE

UNITE DE TRAITEMENT ET MEMOIRE DONNEES

SYNC
CORRECTOR_IN → EN

CLK

DATA IN

SYNC → EN → CORRECTOR_OUT

CLK

CLK

8

8'

1, 1'

**Fig. 6**

RST

EN

RESTART

CLK

OUT

3

**Fig. 7**

Fig. 8

| SEQ_EN | OUT_EN | NEG_EN | D_EN | D_ADDR | | B_ADDR | D_SEL |
|---|---|---|---|---|---|---|---|

| A_SEL | A_ADDR |
|---|---|
| | COEFF_ADDR |

Fig. 9

Fig. 10

| | |
|---|---|
| 0 | x(n) |
| 1 | -x(n-1); -x(n) |
| 2 | y1(n-1); y1(n) |
| 3 | y2(n-1); y2(n) |
| 4 | y3(n-1); y3(n) |
| 5 | x(n)-x(n-1) |
| 6 | -B1y1(n-1); x(n)+y1(n) |
| 7 | -B2y2(n-1); y2(n)+y3(n) |
| 8 | -B3y3(n-1); y(n) |
| 9 | A1(x(n)-x(n-1)) |
| A | A2(x(n)-x(n-1)) |
| B | A3(x(n)-x(n-1)) |

6'

## Fig. 11

| | |
|---|---|
| 0 | A1 |
| 1 | B1 |
| 2 | A2 |
| 3 | B2 |
| 4 | A3 |
| 5 | B3 |

6

## Fig. 12

**EP 2 315 085 B1**

## RÉFÉRENCES CITÉES DANS LA DESCRIPTION

### Documents brevets cités dans la description

- US 5349296 A

- WO 8908852 A